# EUROPEAN PATENT SPECIFICATION

(11) **EP 0 353 470 B1**
(45) Date of publication and mention of the grant of the patent: **30.11.1994**
(21) Application number: 89112092.5
(22) Date of filing: 03.07.1989
(51) Int. Cl.: G03F 7/004, G03F 7/16, G03F 7/38, G03F 7/022

(54) **Method and composition for improving silylation of resists**
Verfahren und Zusammensetzung für Resistsilylierung
Méthode et composition pour la silylation des photoréserves

(30) Priority: 01.08.1988 US 226597
(43) Date of publication of application: 07.02.1990
(73) Proprietor: International Business Machines Corporation, Armonk, N.Y. 10504 (US)
(72) Inventor: Gleason, Robert T., Burlington Vermont 05401 (US); Linde, Harold G., Richmond Vermont 05477 (US)
(74) Representative: Schäfer, Wolfgang, Dipl.-Ing.

(56) References cited:
- DE-A- 2 514 213
- US-A- 4 263 392
- PATENT ABSTRACTS OF JAPAN, vol. 9, no. 173 (E-329)[1896], 18th July 1985 ; & JP-A-60 46 026

## Description

This invention relates generally to silylation of photoresists and more particularly to a process for improving the susceptibility of phenolic photoresist resins to silylation, and such improved photoresist composition. In even more particular aspects, the invention relates to a process of adding a pore creating component to photoresists, especially a photoresist containing a relatively high molecular weight polymer component and the resulting composition for improved silylation properties.

In the practice of photolithography, silylation is a process in which a photoresist material is converted to an etch mask following exposure to radiation. The process of silylation is performed by contacting the imaged resist to a reactive silicon containing compound such as a silazane as hexamethylcyclotrisilazane (HMCTS) or the like. This will selectively add silicon to the resist at the exposed or unexposed areas depending upon development and/or whether it is a positive or negative image. Resist material without added silicon will etch away under oxygen reactive ion etching (O₂RIE) conditions whereas material containing sufficient silicon will act as an etch mask. This silylation process is described in U.S. Patent 4,552,833.

In Patent Abstracts of Japan, Vol. 9, No. 173 (E-329) (1976), 10.07.85, a process is described for forming pores in a polymeric photoresist material by adding a pore-creating material to the polymer and subsequently leading this material by use of a solvent.

It has been observed that certain phenolic resin containing photoresists, especially photoresists having a large percentage of high molecular weight components, exhibit poor silylation properties. Examples of phenolic resins are shown in U.S. Patents 4,491,628 and 3,661,582.

It has also been observed that as the loading of photoactive compound (PAC) in the photoresist increases, the silylation properties of the photoresist during wet silylation increase, even with those resins of higher molecular weight suggesting that the PAC which is leached out may provide additional pores or openings. However, the optimum loading of the photoactive compounds may not permit increased loadings to enhance silylation properties. The exact reason for the poorer behavior of certain resists as compared to others is not completely understood. However, it is believed one of the principal reasons certain resists have poorer behavior than others is that there is a reduced number of pores or openings of sufficient size in the resin component of photoresists which have higher molecular weight to allow the entry of the silylating compound into the resist to react at reactive sites. Hence there is insufficient silicon deposited to form an effective etch mask.

According to the present invention, a process for enhancing the silylation properties of a photoresist composition and the resulting composition are provided. This improvement includes incorporation in the formulation of the photoresist of a pore creating component which is inert with respect to the polymeric resin of the photoresist and PAC, and which material can be leached out of the photoresist, and further which material is of sufficiently large molecular volume to permit diffussion of a silylating compound into the voids left after it has been leached out.

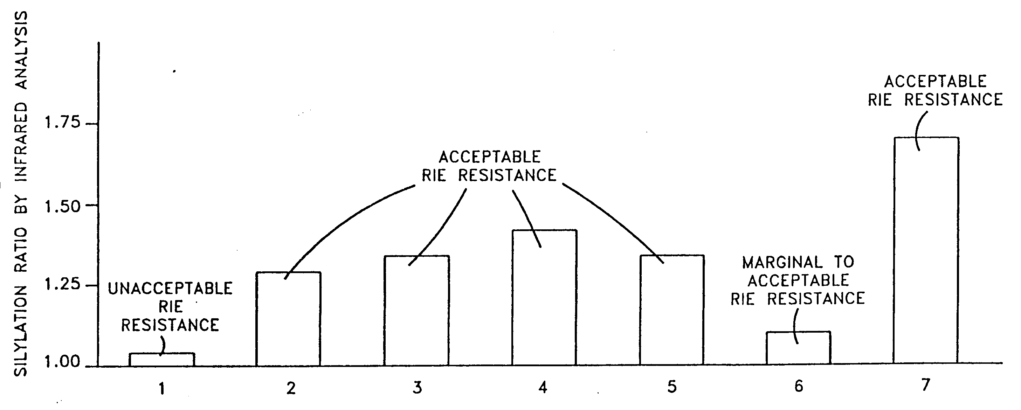

The single Figure is a bar graph showing silylation ratios of various resins formed according to this invention as compared to prior art resins.

In the process known as silylation, a photoresist mask is converted to an etch mask following exposure to radiation in a photolighographic process. The photoresist mask typically contains a phenolic polymer component and a photoactive compound (PAC) component. Following exposure and developing, the remaining imaged material is subjected to a silylation treatment wherein a silicon containing compound is introduced into the structure of the resist material, and the silicon moiety will convert the material to a mask which will resist oxygen reactive ion etching (O₂RIE). One conventional method of introducing the silicon moiety is to contact the mask material remaining after exposure and developing with a solution containing a solvent and a reactive organosilicon compound. One typical solution is a solution of hexamethylcyclotrisilazane (HMCTS) in xylene. By a mechanism that is not completely under stood, but which is believed to involve reaction of the silicon at active sites in the polymeric material and/or PAC, the silicon is incorporated as a part of the structure.

It has been found that certain photoresist materials are more receptive to reaction of silicon than others. For example, it has been observed that in general those phenolic resists having a high percentage of the photoactive component (PAC) are more susceptible to silylation than those with a power percentage of PAC, and also that those resists having a higher percentage (i.e. 12% or more) of high molecular weight component (i.e. greater than about 10,000) are less susceptible to silylation than those with lower percentages of high molecular weight components. Thus while some control of silylation effectiveness can be accomplished by controlling the properties of the resists and the PAC, in many cases other considerations mitigate against increasing the PAC or varying the molecular weights.

It has been found that by incorporating into the photoresist composition a pore creating component, the silylation ability or effectiveness of the photoresist can be significantly increased. The pore creating composition should have the properties of being inert with respect to the polymer and PAC and of sufficiently large molecular volumes to allow diffusion of the silylating component into the resin. The pore creating component is one that can be dissolved out or otherwise removed either before or concomittantly with the silylation process. Preferably, this can be accomplished by selecting the pore creating component to be soluble in the solvent in which the silylating compound is dissolved, and allowing the solvent to dissolve the pore creating component during the process of silylation. In this case, as the pore creating compound is leached out and the pores created, the silicon moiety is deposited in the cavities thus created.

While many pore creating compounds have been used, esters, carboxylic acids, phenolics, and amides are especially useful. Of particular use when solutions such as xylene are used are benzyl benzoate, abietic acid, butylated hydroxytoluene, and n-butylphthalamic acid. All of these compounds have significantly increased the effectiveness of silylation of many different photoresist compositions, but they are especially useful when incorporated in resists which have a high percentage (over about 12%) of high molecular weight compounds (above about 10,000) in the resin.

The single Figure is a bar graph representing the effectiveness of silylation of certain photoresists both with and without pore creating components and represent graphically the results of experiments listed in examples 1 through 7 below.

Examples 1 through 5 are samples of a novolac resin (a cresol formaldehyde resin of the type that can be purchased from such suppliers as Shipley Company or Kodak Corp.), which has a relatively high percentage of high molecular weight component, i.e. above 12% above 10,000 as calculated by UV size exclusion chromatography at 280 nm. This determination is best carried out on a skewed column set containing only 50 nm and 10 nm pore sizes for retention. Samples 6 and 7 are novolac resin having only about 8% of high molecular weight component above 10,000.

Examples 1 and 6 did not have any pore creating component added thereto, and Example 2, 3, 4, 5, and 7 had pore creating components added as follows.
- Example 2: -- butylated hydroxytoluene
- Example 3: -- benzyl benzoate
- Example 4: -- abietic acid
- Example 5: -- n-butylphthalamic acid
- Example 7: -- aromatic carboxylic acid

In each of these examples the resist films were prepared by adding 200mg of component to 5ml of the novolac resist containing PAC. The resists were applied to a silicon wafer and heated at 100° for 90 seconds to form a coherent film. The unexposed films were then treated in a solution of 10% HMCTS in xylene containing 0.5% n-methylpyrrolidinone for 15 minutes. The majority of silylation occurred within 5 minutes exposure, but additional time increases silylation.

The silylation ratio of each of the films, after 5 minutes treatment in the HMCTS solution was determined using IR spectroscopy and calculated by dividing the methylsilicon absorption at 1270cm⁻¹ (wave numbers) by the aromatic ring absorption at 1500cm⁻¹ (wave numbers). The higher the value, the greater the amount of silylation that took place.
- Example 1: -- 1.04
- Example 2: -- 1.29
- Example 3: -- 1.34
- Example 4: -- 1.42
- Example 5: -- 1.34
- Example 6: -- 1.10
- Example 7: -- 1.70

Example 1, which had a high percentage of high molecular weight components (15.8%) had a very low silylation ratio, e.g. 1.04, and Example 6, which had lower levels of high molecular weight components (8%), had a somewhat higher silylation ratio. However, as can be seen in the case of both types of resins, the addition of a pore creating component significantly increases the silylation ability of the photoresist even increasing that of the resin having a high percentage of high molecular weight components to levels greater than that of the other resin without addition.

In actual tests involving the use of masks formed by silylation for O₂RIE, the resists that were formed with pore creating components after silylation resisted etching and performed significantly better than masks formed from resin without the pore creating components. In fact, in some instances of photoresists having a high percentage of high molecular weight components, masks formed using pore creating components were the difference between a mask that performed acceptably and one that had insufficient silicon moiety to be useful in this type of reactive ion etching. With respect to those resists of Examples 1 through 7, the resist of Example 1 had unacceptable properties as a mask, and the resist of Example 6 had only marginally acceptable properties. However, those resists of Examples 2 through 5, and 7, each of which had a pore creating component according to this invention added thereto, each performed satisfactorily as resist masks.

It should be noted that the exact amount of pore creating component to be added to the photoresist can vary. Even a small amount is of some benefit, and the more that is added the more pores that will be created. Of course, there cannot be so much of the pore creating component added that it affects the polymeric integrity, but as long as the structure remains coherent after silylation any amount can be used. Polymer composition, PAC, and pore creating components should be optimized for specific applications as a viable resist.

It is also to be understood that the pore creating material is not useful only with silylation in the HMCTS-xylene system, but can be used with other systems where a metallic moiety is to be introduced into a polymeric structure, such as for creating an RIE mask.

## Claims

1. Process for promoting the incorporation of a metallic component into a structure of polymeric material comprising the steps of:
adding a pore-creating component to a formulation comprising the polymeric material, said pore-creating material being inert with respect to said polymeric material, and any other materials in the formulation,
forming a film of said polymeric material with a resulting structure of the porecreating material dispersed within a coherent polymeric film,
leaching out from said film said porecreating material and exposing the resultant porous structure to an organometallic component in which the metallic moiety contains the metal to be incorporated into the structure,
said pore-creating material being of a sufficiently large molecular volume to permit diffusing of the organometallic component into the porous structure of polymer from which the pore-creating component has been removed;
whereby the resulting structure of a polymer with a diffused metallic component is provided.

2. Process as claimed in claim 1, wherein the pore-creating component is leached out with a solvent.

3. Process as claimed in claim 2, wherein the organometallic component is contained in said solvent and the leaching out of the porecreating component and exposing of the structure to the organometallic component is a single process step.

4. Process as claimed in claim 1, wherein the metal moiety is silicon.

5. Process as claimed in claims 3 and 4, wherein the organo-metallic component is hexamethylcyclotrisilazane.

6. Process as claimed in claims 1 and 2, wherein the pore-creating component is selected from the group consisting of esters, carboxylic acids, phenolics, and amides.

7. Process as claimed in claim 6, wherein the pore-creating component is selected from the group benzyl benzoate, abietic acid, butylated hydroxy toluene, and n-butylphthalamic acid.

8. Process as claimed in claim 2, wherein the solvent is xylene.

9. Process as claimed in claim 1, wherein the polymeric material is a phenolic resin.

10. Process as claimed in claim 1, wherein the polymeric material includes a photoactive component.

11. Photoresist composition comprising, a polymeric material, a photoactive compound dispersed therein, and a pore creating component dispersed therein, said pore creating component being of sufficient atomic volume to allow after its removal entry of a silylating organometallic compound, said pore creating component being selected to be leachable in a solvent which is inert to said polymer.

## Patentansprüche

1. Verfahren zur Förderung des Einbaus eines metallischen Bestandteils in ein aus polymerem Material bestehendes Gefüge, das folgende Schritte umfaßt:
das Zugeben eines Poren erzeugenden Bestandteils zu einer das polymere Material enthaltenden Formulierung, wobei das Poren erzeugende Material gegenüber dem polymeren Material und allen anderen in der Formulierung vorhandenen Materialien inert ist,
die Bildung einer aus dem polymeren Material bestehenden Schicht, bei der sich ein Gefüge ergibt, in dem das Poren erzeugende Material innerhalb einer kohärenten polymeren Schicht verteilt ist,
das Herauslösen des Poren erzeugenden Materials aus der Schicht, wobei das sich ergebende poröse Gefüge dann einem metallorganischen Bestandteil ausgesetzt wird, bei dem die metallische Komponente das in das Gefüge einzubauende Metall enthält,
wobei das Poren erzeugende Material ein ausreichend großes Molvolumen aufweist, so daß der metallorganische Bestandteil in das poröse Gefüge des Polymers, aus dem der Poren erzeugende Bestandteil entfernt worden ist, diffundiert;
wodurch man ein Polymer mit einem Gefüge mit diffundiertem metallischen Bestandteil erhält.

2. Verfahren nach Anspruch 1, bei dem der Poren erzeugende Bestandteil mit einem Lösungsmittel herausgelöst wird.

3. Verfahren nach Anspruch 2, bei dem der metallorganische Bestandteil in dem Lösungsmittel enthalten ist und das Herauslösen des Poren erzeugenden Bestandteils und das Aussetzen des Gefüges gegenüber dem metallorganischen Bestandteil ein einziger Verfahrensschritt sind.

4. Verfahren nach Anspruch 1, bei dem die Metallkomponente Silizium ist.

5. Verfahren nach Ansprüchen 3 und 4, bei dem der metallorganische Bestandteil Hexamethylzyklotrisilazan ist.

6. Verfahren nach Ansprüchen 1 und 2, bei dem der Poren erzeugende Bestandteil aus der Gruppe bestehend aus Estern, Karbonsäuren, Phenolharzen und Amiden bestehenden Gruppe ausgewählt wird.

7. Verfahren nach Anspruch 6, bei dem der Poren erzeugende Bestandteil aus der Gruppe bestehend aus Benzylbenzoat, Abietinsäure, butyliertes Hydroxytoluol und n-Butylphthalamidsäure ausgewählt wird.

8. Verfahren nach Anspruch 2, bei dem das Lösungsmittel Xylol ist.

9. Verfahren nach Anspruch 1, bei dem das polymere Material ein Phenolharz ist.

10. Verfahren nach Anspruch 1, bei dem das polymere Material einen fotoaktiven Bestandteil umfaßt.

11. Ein Fotoresist, der sich aus einem polymeren Material, einer darin verteilten fotoaktiven Verbindung und einem darin verteilten Poren erzeugenden Bestandteil zusammensetzt, wobei der Poren erzeugende Bestandteil ein Atomvolumen aufweist, das ausreicht, um nach Entfernen desselben das Eindringen einer silylierenden, metallorganischen Verbindung zu gestatten, wobei der Poren erzeugende Bestandteil im Hinblick darauf ausgewählt wird, daß er in einem dem Polymer gegenüber inerten Lösungsmittel herausgelöst werden kann.

## Revendications

1. Procédé pour promouvoir l'incorporation d'un composant métallique dans une structure de matériau polymérique, comprenant les étapes suivantes:
- l'addition d'un composant de création de pores dans une formulation comprenant le matériau polymérique, ledit matériau de création de pores étant inerte par rapport audit matériau polymérique, et tout autre matériau de la formule;
- la formation d'un film dudit matériau polymérique avec une structure résultante du matériau de création de pores dispersée dans un film polymérique cohérent;
- l'extraction par lessivage dudit film, dudit matériau de création de pores et exposition de la structure poreuse obtenue à un composant organométallique dans lequel la portion métallique contient le métal à incorporer dans la structure;
- ledit matériau de création de pores ayant un volume moléculaire suffisament important pour permettre la diffusion du composant organo-métallique dans la structure poreuse de polymère d'où le composant de création de pores a été retiré;
l'exécution de ces étapes permettant la réalisation d'une structure d'un polymère avec un composant métallique diffusé.

2. Le procédé de la revendication 1 dans lequel le composant de création de pores est extrait par lessivage avec un solvant.

3. Le procédé de la revendication 2 dans lequel le composant organo-métallique est contenu dans ledit solvant et l'extraction par lessivage du composant de création de pores et l'exposition de la structure au composant organo-métallique constituent une seule étape.

4. Le procédé de la revendication 1 dans lequel la portion de métal est en silicium.

5. Le procédé des revendications 3 et 4 dans lequel le composant organo-métallique est de l'héxaméthylcyclotrisilazane.

6. Le procédé des revendications 1 et 2 dans lequel le composant de création de pores est sélectionné dans le groupe composé d'esters, d'acides carboxyliques, de phénoliques et d'amides.

7. Le procédé de la revendication 6 dans lequel le composant de création de pores est choisi dans le groupe composé de benzoate de benzyle, d'acide abiétique, du toluène hydroxy butylé et d'acide n-butylphthalamique.

8. Le procédé de la revendication 2 dans lequel le solvant est du xylène.

9. Le procédé de la revendication 1 dans lequel le matériau polymérique est une résine phénolique.

10. Le procédé de la revendication 1 dans lequel le matériau polymérique comprend un composant photoactif.

11. Composition de matériau photorésistant comprenant un matériau polymérique, un composé photoactif dispersé dans celui ci, et un composant de création de pores dont le volume atomique est suffisant pour permettre après son retrait, l'entrée d'un composé organo-métallique silylateur, ledit composant de création de pores étant choisi de façon à pouvoir être extrait par lessivage dans un solvant qui est inerte par rapport audit polymère.
